# EUROPÄISCHE PATENTSCHRIFT

(11) **EP 2 071 635 B1**
(45) Veröffentlichungstag und Bekanntmachung des Hinweises auf die Patenterteilung: **03.05.2017**
(21) Anmeldenummer: 08450186.5
(22) Anmeldetag: 18.11.2008
(51) Int. Cl.: H01L 31/048, H01L 31/068, B32B 3/18

(54) **Gekrümmte Photovoltaik-Module und Verfahren zu deren Herstellung**
Cambered photovoltaic module and method for its manufacture
Modules photovoltaïques courbés et leur procédé de fabrication

(30) Priorität: 11.12.2007 AT 20032007
(43) Veröffentlichungstag der Anmeldung: 17.06.2009
(73) Patentinhaber: ICGH Investment and Consulting GmbH, 1150 Wien (AT)
(72) Erfinder: Hornbachner, Dieter, Dipl.-Ing. Dr.techn., 1170 Wien (AT); Kirschner, Markus, Dipl.-Ing. Dr.techn., 2340 Mödling (AT)
(74) Vertreter: Weiser, Andreas

(56) Entgegenhaltungen:
- EP-A2- 0 509 615
- EP-A2- 1 858 087
- GB-A- 2 139 917
- SCHNEIDER A ET AL: "A New Approach in Solar Cell Module Interconnection Technique Resulting in 5-10% Higher PV Module Power Output", CONFERENCE RECORD OF THE 2006 IEEE 4TH WORLD CONFERENCE ON PHOTOVOLTAIC ENERGY CONVERSION (IEEE CAT. NO.06CH37747), IEEE, 1 May 2006 (2006-05-01), pages 2073-2076, XP031007748, ISBN: 978-1-4244-0016-4

## Beschreibung

Die vorliegende Erfindung betrifft ein Verfahren zur Herstellung eines gekrümmten Photovoltaik-Moduls ausgehend von ebenen kristallinen Solarzellen. Die Erfindung betrifft ferner ein gekrümmtes Photovoltaik-Modul und einen Standpfahl für eine solarbetriebene Leuchte mit solchen Modulen.

Für die Herstellung gekrümmter Photovoltaik-Module werden bislang vorrangig Dünnschicht-Solarzellen aus polymerem oder amorphem Material verwendet, welche flexibel sind und enge Krümmungsradien gestatten. Allerdings haben Solarzellen dieser Art einen wesentlich geringeren Wirkungsgrad als kristalline Solarzellen; es wurden daher bereits verschiedene Versuche unternommen, gekrümmte Photovoltaik-Module mit Hilfe kristalliner Solarzellen aufzubauen.

Beispielsweise ist es aus der EP 1 564 816 A1 bekannt, mono- oder polykristalline Solarzellen soweit zu verbiegen, daß sie nicht brechen, was nur schwache Krümmungen gestattet. In der WO 03/069682 A2 und der WO 03/005457 A2 werden gekrümmte Photovoltaik-Module aus kristallinen Solarzellen mit einer Dikke von weniger als 150 µm bzw. 200 µm vorgeschlagen, was etwas stärkere Krümmungen zuläßt, ohne daß die kristalline Struktur beschädigt wird, jedoch immer noch keine engen Krümmungsradien zuläßt. Die Fertigung sehr dünner Zellen ist überdies aufwendig und für Alltagsanwendungen nicht geeignet. Schließlich ist es aus der US 4 152 536 A bekannt, Kristalle in gekrümmter Form als Ausgangsmaterial für Solarzellen zu züchten, was ein besonders aufwendiges Verfahren darstellt.

Die Erfindung setzt sich zum Ziel, ein Verfahren zur Herstellung von gekrümmten Photovoltaik-Modulen aus kristallinen Solarzellen zu schaffen, welches enge Krümmungsradien gestattet und kostengünstig ausgeführt werden kann.

Dieses Ziel wird in einem ersten Aspekt der Erfindung mit einem Verfahren der einleitend genannten Art erreicht, das sich auszeichnet durch die Schritte:
Einbetten zumindest einer ebenen kristallinen Solarzelle vom rückseitenkontaktierten Typ zwischen einer verformbaren Trägerschicht und einer verformbaren Deckschicht, um ein Laminat zu erzeugen, und
Krümmen des Laminats zur gewünschten konvexen Form unter Verformen der Träger- und Deckschichten und gleichzeitigem Brechen der zumindest einen Solarzelle zu Bruchstücken, sodass die konvexe Form durch Polygonzüge der Bruchstücke angenähert wird,
wobei die Bruchstücke über eine sich an den Bruchstellen verbiegende metallische Rückseitenkontaktierung miteinander verbunden bleiben.

Eine alternative Variante des Verfahrens der Erfindung zeichnet sich aus durch die Schritte:
Einbetten zumindest einer ebenen kristallinen Solarzelle vom drahtgitterkontaktierten Typ zwischen einer verformbaren Trägerschicht und einer verformbaren Deckschicht, um ein Laminat zu erzeugen, und
Krümmen des Laminats zur gewünschten Form unter Verformen der Träger- und Deckschichten und gleichzeitigem Brechen der zumindest einen Solarzelle zu Bruchstücken, sodass die konvexe Form durch Polygonzüge der Bruchstücke angenähert wird,
wobei die Bruchstücke über ein sich an den Bruchstellen dehnende metallische Drahtgitterkontaktierung miteinander verbunden bleiben.

In Abkehr von den bisher bekannten Lösungen schlägt die Erfindung ein systematisches Zerbrechen ebener kristalliner Solarzellen vor, um die gewünschten Krümmungen zu erzeugen. Die Erfindung beruht insbesondere auf der Erkenntnis, daß selbst ein kleinteiliges Brechen der Solarzellen überraschenderweise zu keinem signifikanten Leistungsabfall der Solarzellen führt, wenn bestimmte Typen von Solarzellen eingebettet in ein Laminat verwendet werden, und zwar Solarzellen vom drahtgitter- oder rückseitenkontaktierten Typ.

Unter rückseitenkontaktierten Solarzellen werden in der vorliegenden Beschreibung alle Arten von Solarzellen verstanden, bei welchen zumindest einige der Vorderseitenkontaktierungen, z.B. die sog. Busbars, mittels entsprechender Durchkontaktierungen durch den Kristallkörper zur Rückseite des Kristallkörpers verlegt sind, wie bei sog. "metallization wrap around"-Zellen (MWA), "metallization wrap through"-Zellen (MWT) oder "emitter wrap through"-Zellen (EWT). Da hier keine oder nur wenige Leiterbahnen auf der Vorderseite der Solarzelle verlaufen, werden beim konvexen Brechen der Solarzellen nach hinten auch keine oder nur wenige Leiterbahnen beschädigt und die Bruchstücke bleiben über die sich verbiegende, sonst aber intakt bleibende Rückseitenkontaktierung verbunden.

Unter drahtgitterkontaktierten Solarzellen werden in der vorliegenden Beschreibung Solarzellen verstanden, die anstelle der üblichen siebgedruckten oder aufgedampften Kontaktierung eine beliebige Anordnung, z.B. ein Netz, von feinen Metalldrähten zur Kontaktierung zumindest der Vorderseite (primäre Lichteinfallseite) der Solarzelle aufweisen. Während Siebdruck- oder Aufdampfkontaktierungen an den Bruchspalten zwischen den Bruchstücken zerreißen würden, können sich Metalldrähte dehnen und damit die Bruchspalte der Kristallstruktur überspannen.

Durch das Einbetten der Solarzellen vor dem Brechen in die Träger- und Deckschicht bleibt dabei die Integrität des Photovoltaik-Moduls im gekrümmten Zustand erhalten, wobei die erzielten Krümmungsverläufe genau genommen durch Polygonzüge von kleinteiligen Bruchstücken angenähert sind, welche Näherung unter den hier verwendeten Begriff von "Krümmung" subsumiert wird. Im Ergebnis wird auf überraschend einfache und kostengünstige Art und Weise ein gekrümmtes Photovoltaik-Modul mit hohem Wirkungsgrad erzielt, das auch enge Krümmungen einnehmen kann.

Bevorzugt können die Solarzellen vor dem Einbetten mit Schwächungslinien versehen werden, um Sollbruchstellen für das Brechen zu erzeugen. Dadurch können besonders regelmäßige Bruchstücke und gleichmäßige Krümmungsverläufe erreicht werden.

Besonders vorteilhaft ist es dabei, wenn die Schwächungslinien durch Ritzen mit einem Laser erzeugt werden, was hohe Präzision erzielt.

Ferner ist es besonders günstig, wenn gemäß einem weiteren bevorzugten Merkmal der Erfindung Träger- und Deckschichten aus thermoplastischen Folien verwendet werden und das Einbetten durch Einlaminieren der Solarzelle in die Folien mittels einer Heizpresse erfolgt. Dies ergibt ein kompaktes, gut verbundenes Laminat, das für eine Weiterverarbeitung besonders gut geeignet ist, wie später noch erörtert wird.

Bevorzugt werden nicht nur eine, sondern gleich mehrere Solarzellen flächig nebeneinanderliegend angeordnet, über flexible elektrische Leiter verbunden und gemeinsam zwischen Träger- und Deckschicht eingebettet, wodurch sich auch großflächige Photovoltaik-Module herstellen lassen.

Gemäß einer ersten bevorzugten Variante der Erfindung erfolgt das Krümmen durch Pressen des Laminats zwischen einem Formstempel und einer entsprechenden Matrize. Dadurch lassen sich beliebige Krümmungsverläufe herstellen.

Gemäß einer alternativen Variante der Erfindung, welche zur Herstellung eines rohrförmigen Photovoltaik-Moduls dient, erfolgt das Krümmen durch Einrollen des Laminats zu einem rohrförmigen Halbzeug, welches anschließend in ein transparentes Rohr eingebracht und auf dessen Innenseite auflaminiert wird. Mit Hilfe dieses Verfahrens lassen sich Rohre mit sehr geringem Durchmesser vollflächig mit Solarzellen ausstatten.

Bevorzugt erfolgt das Auflaminieren mit Hilfe eines in das Halbzeug eingeführten Preßschlauches, welcher mit Über- oder Unterdruck beaufschlagt werden kann und einen gleichmäßigen Anpreßdruck im Inneren des Rohres erzeugt.

Besonders vorteilhaft ist es dabei, wenn bei Verwendung einer Deckschicht aus thermoplastischem Material das Auflaminieren des Halbzeugs auf die Innenseite des Rohres unter Wiedererwärmen der thermoplastischen Deckschicht erfolgt, was zusätzliches Verbindungsmaterial erspart.

Optional kann auf die Innenseite des Halbzeugs eine Schutzfolie auflaminiert werden; bei Verwendung einer Trägerschicht aus thermoplastischem Material bevorzugt ebenfalls durch Wiedererwärmen der thermoplastischen Trägerschicht.

Für das genannte Auflaminieren mittels Wiedererwärmen thermoplastischer Träger- und Deckschichten ist es besonders günstig, wenn gemäß einem weiteren Merkmal der Erfindung die Träger- und Deckschichten zunächst in der Heizpresse eine rauhe Oberflächenstruktur erhalten, besonders bevorzugt durch Zwischenlegen von oberflächenstrukturierten Prägefolien oder -netzen, die nach dem Preßvorgang entfernt werden. Die rauhe Oberflächenstruktur fördert das Entweichen von Luft bei den Auflaminiervorgängen des Halbzeugs, so daß Lufteinschlüsse vermieden werden.

In einem weiteren Aspekt betrifft die Erfindung auch ein Photovoltaik-Modul, das nach dem Verfahren der vorgestellten Art erzeugt wurde.

In noch einem weiteren Aspekt schafft die Erfindung schließlich einen Standpfahl für eine solarbetriebene Leuchte, der zumindest ein Photovoltaik-Modul der vorgestellten Art enthält.

Die Erfindung wird nachstehend anhand von in den beigeschlossenen Zeichnungen dargestellten Ausführungsbeispielen näher erläutert. In den Zeichnungen zeigen:
die Fig. 1 bis 3 das Verfahren der Erfindung zur Herstellung eines gekrümmten Photovoltaik-Moduls in drei aufeinanderfolgenden Stadien jeweils in einem schematischen Schnitt durch das Modul;
die Fig. 4a, 4b, 5a und 5b weitere Verfahrensschritte zur Herstellung eines rohrförmigen Photovoltaik-Moduls gemäß der Erfindung;
Fig. 6 den Aufbau einer drahtgitterkontaktierten Solarzelle zur Verwendung in dem erfindungsgemäßen Verfahren in einer schematischen Perspektivansicht;
die Fig. 7 und 8 verschiedene Bruchverhalten der Solarzelle von Fig. 6 während des Verfahrens der Erfindung jeweils in einer schematischen Perspektivansicht;
Fig. 9 eine erste Variante einer rückseitenkontaktierten Solarzelle zur Verwendung in dem erfindungsgemäßen Verfahren in einer schematischen Perspektivansicht;
Fig. 10 eine perspektivische Untersicht der Solarzelle von Fig. 9;
Fig. 11 das Bruchverhalten der Solarzelle von Fig. 9 während des Verfahrens der Erfindung in einer schematischen Perspektivansicht;
Fig. 12 eine zweite Variante einer rückseitenkontaktierten Solarzelle zur Verwendung in dem erfindungsgemäßen Verfahren in einer schematischen Perspektivansicht;
Fig. 13 einen Schnitt durch die Solarzelle von Fig. 12 in Richtung der Pfeile A-A; und
Fig. 14 das Bruchverhalten der Solarzelle von Fig. 12 während des Verfahrens der Erfindung in einer schematischen Perspektivansicht.

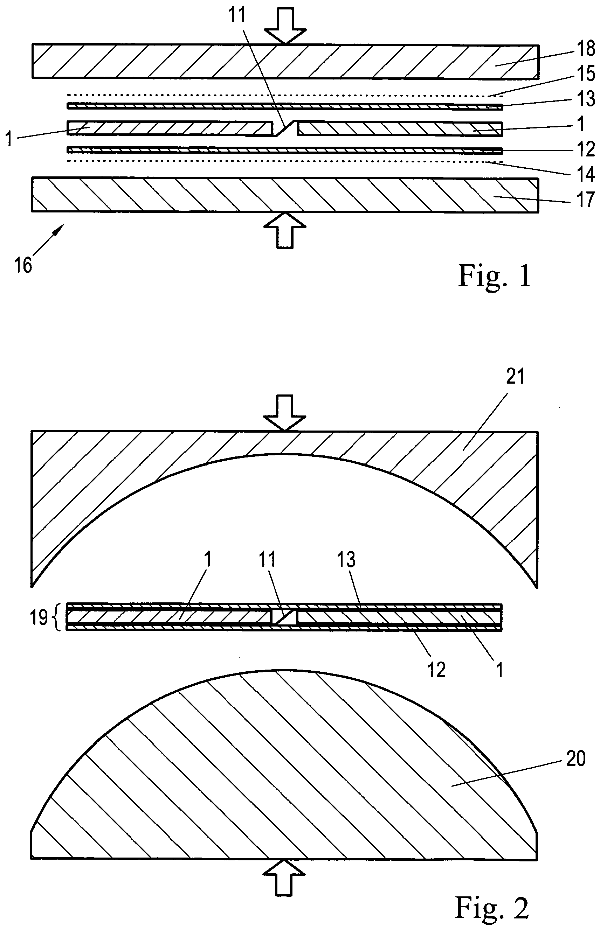

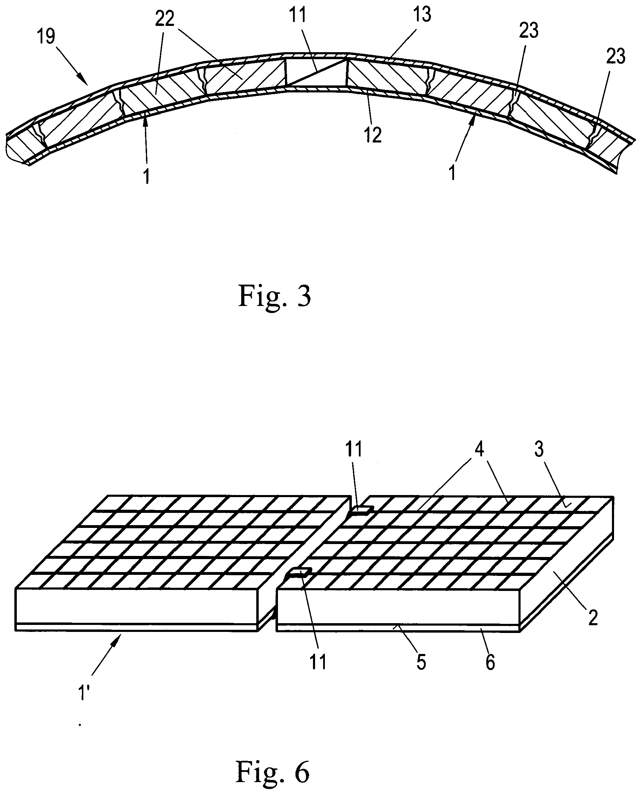

Das Verfahren zur Herstellung eines gekrümmten Photovoltaik-Moduls wird nun anhand der Fig. 1 - 3 näher erläutert. Das Verfahren geht von ebenen kristallinen Solarzellen 1 aus, welche anhand der Fig. 6 - 14 ausführlicher erläutert werden. Geeignete Kristallmaterialien für die Solarzellen 1 sind beispielsweise Silizium (Si) oder Galliumarsenid (GaAs), wie dem Fachmann bekannt.

Fig. 6 zeigt schematisch eine erste Variante 1' von Solarzellen 1 vom drahtgitterkontaktierten Typ. Die Solarzelle 1' umfaßt einen kristallinen Grundkörper 2 aus Si-Material, der auf seiner Vorderseite 3 (Lichteinfallsseite) mit einem feinen Gitter von Metalldrähten 4 als elektrische Kontaktierung der Vorderseite versehen ist. Die Rückseite 5 der Solarzelle 1' ist mit einer vollflächigen, z.B. aufgedruckten oder aufgedampften, Metallisierung 6 als Rückseitenkontaktierung versehen. Wird anstelle einer vollflächigen Metallisierung 6 ebenfalls ein Gitter von Metalldrähten 4 zur Rückseitenkontaktierung verwendet, ist die Solarzelle 1' auch für beidseitigen Lichteinfall geeignet.

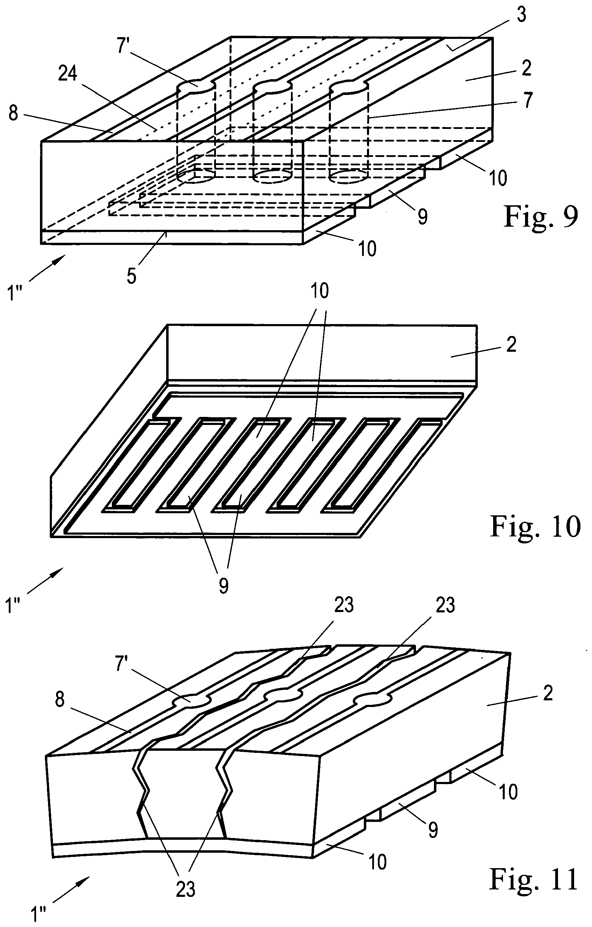

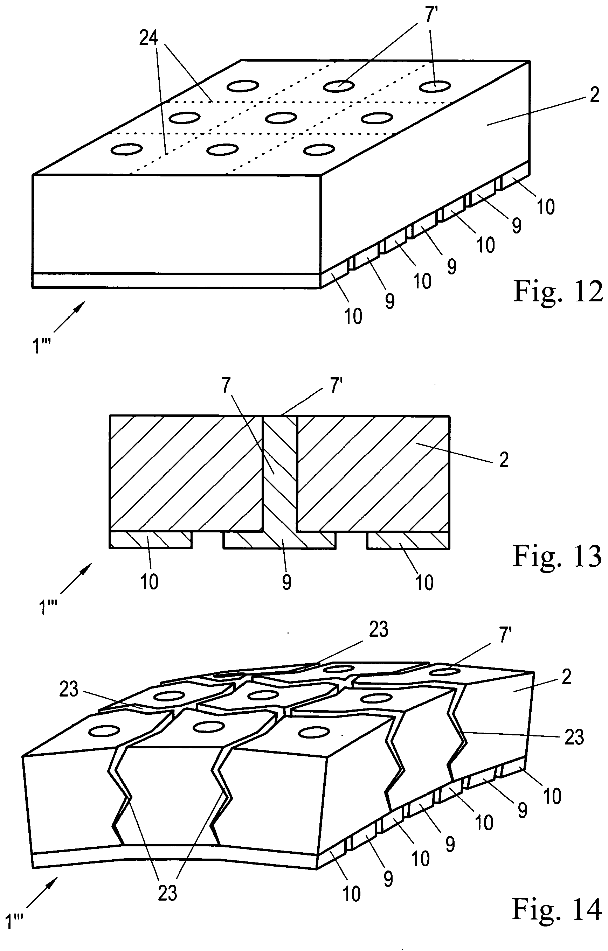

Die Fig. 9 und 12 zeigen in schematisierter Form zwei weitere Varianten 1" und 1"' von Solarzellen 1, die für das Verfahren der Erfindung geeignet sind, und zwar vom rückseitenkontaktierten Typ. Bei solchen rückseitenkontaktierten Solarzellen ist zumindest ein Teil der zur Kontaktierung der Vorderseite 3 erforderlichen Leiterbahnen auf die Rückseite 5 verlegt, um Abschattungsverluste durch die Vorderseitenkontaktierung zu verringern, u.zw. vor allem die Busbars und gegebenenfalls auch davon abzweigende "Finger". Dazu werden Kanäle 7 - hier stark vergrößert dargestellt - mittels Laser durch den Grundkörper 2 gebohrt und mit einer elektrisch leitenden Durchkontaktierung versehen, beispielsweise durch Einbringen einer leitfähigen Siebdruckpaste. An der Vorderseite 3 münden die Kanäle 7 in Form punktförmiger Emitter 7' aus, von welchen bei der Solarzelle 1" Finger 8 ausgehen ("metalization wrap through", MWT) oder welche bei der Solarzelle 1"' frei stehen bleiben ("emitter wrap through", EWT). An der Rückseite 5 werden die durchkontaktierten Kanäle 7 mittels der dorthin verlegten Busbars 9 kontaktiert, welche mit einer streifenförmigen Rückseitenkontaktierung 10 verzahnt sind (Fig. 10), wie dem Fachmann bekannt.

Zurückkommend auf Fig. 1 werden mehrere solche Solarzellen 1', 1", 1'", im weiterem unter dem Bezugszeichen "1" zusammengefaßt, flächig nebeneinander angeordnet und über flexible elektrische Leiter 11 miteinander verbunden, z.B. seriengeschaltet, wie in den Fig. 1 und 6 ersichtlich. Selbstverständlich lassen sich beliebige Serien- und Parallelschaltungen der Solarzellen 1 vornehmen, wie in der Technik bekannt, und es kann ein beliebig großes Netz nebeneinanderliegender Solarzellen 1 erzeugt werden.

Das über die Leiter 11 verbundene Netz von Solarzellen 1 wird zwischen eine Trägerschicht 12 und eine Deckschicht 13 eingebracht. Die Deckschicht 13 ist transparent; optional kann auch die Trägerschicht 12 transparent sein, z.B. wenn die Solarzelle 1 für doppelseitigen Lichteinfall geeignet ist.

Die Träger- und Deckschichten 12, 13 sind verformbar, bevorzugt aus Kunststoff, z.B. Ethylenvinylacetat (EVA). Besonders bevorzugt werden thermoplastische Kunststoffe wie Polyvinylbutyral (PVB) verwendet, welche beim Wiedererhitzen wiederaufschmelzbar sind, wie später noch erörtert wird.

Anstelle des Einlaminierens der Solarzellen 1 zwischen zwei gesonderte Träger- und Deckschichten 12, 13 können die Solarzellen 1 alternativ auch direkt in ein Kunststoff- oder Gießharzbett eingebettet werden, z.B. durch Einlegen oder Umgießen; auch ein solches die Solarzellen 1 vollständig umgebendes Bett bildet auf der Vorderseite 3 der Solarzellen 1 eine verformbare Deckschicht und auf der Rückseite 5 der Solarzellen 1 eine verformbare Trägerschicht.

Auf die Träger- und Deckschichten 12, 13 können optional jeweils noch oberflächenstrukturierte Prägefolien 14, 15 aufgelegt werden, um den Außenseiten der Träger- und Deckschichten 12, 13 im anschließenden Preßvorgang eine rauhe Oberflächenstruktur zu verleihen. Anstelle von Prägefolien 14, 15 könnten auch Netze, Gitter usw. zwischengelegt werden.

Anschließend wird der Stapel aus Prägefolie 14, Trägerschicht 12, Netz von Solarzellen 1, Deckschicht 13 und Prägefolie 15 in einer Heizpresse 16 zwischen zwei ebenen Preßbacken 17, 18 unter Druck- und Temperatureinwirkung verpreßt, bis sich die Träger- und Deckschichten 12, 13 mit dem Netz von Solarzellen 1 zu einem Laminat 19 verbinden. Die Prägefolien 14, 15 werden nach dem Preßvorgang entfernt, und das fertige ebene Laminat 19 ist in Fig. 2 als Zwischenprodukt gezeigt.

Gemäß Fig. 2 wird das Laminat 19 zwischen einem Formstempel 20 und einer Matrize 21 so stark gekrümmt, daß die Solarzellen 1 dabei zu einzelnen Bruchstücken 22 zerbrechen. Alternativ kann das Laminat 19 auf jede beliebige andere Art gekrümmt werden, z.B. durch Einrollen mit der Hand usw. Die Einlaminierung der Solarzellen 1 in die Träger- und Deckschichten 12, 13 bewahrt dabei die strukturelle Integrität des derart hergestellten, gekrümmten Photovoltaik-Moduls, wie es in Fig. 3 als Endprodukt gezeigt ist.

Abhängig von dem verwendeten Typ von Solarzellen 1, d.h. entweder vom drahtgitterkontaktierten Typ 1' (Fig. 6) oder vom rückseitenkontaktierten Typ 1", 1'" (Fig. 9, 12), wird dabei die elektrische Kontaktierung der Vorder- und Rückseiten 3, 5 der Solarzellen 1 auf unterschiedliche Art und Weise wie folgt bewahrt.

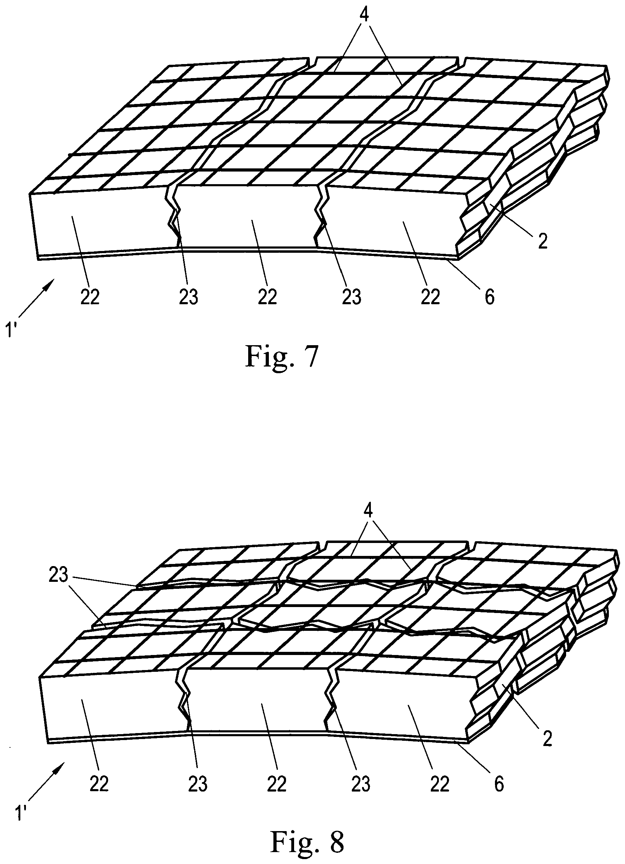

Bei der Ausführungsform von Fig. 6 mit drahtgitterkontaktierten Solarzellen 1' werden die Metalldrähte 4 der Vorderseitenkontaktierung an den Bruchstellen bzw. -spalten 23 zwischen den Bruchstücken 22 gedehnt und überspannen - solange ihre Streckgrenze nicht überschritten wird - die Bruchspalten 23 auf der konvexen Seite der Krümmung, wie in den Fig. 7 und 8 gezeigt. Fig. 7 zeigt das Beispiel einer zylindrischen Krümmung, Fig. 8 das einer sphärischen Krümmung der Solarzelle 1'. Werden Solarzellen 1' verwendet, die sowohl auf ihrer Vorderseite 3 als auch auf ihrer Rückseite 5 mit einer Drahtgitterkontaktierung 4 versehen sind, könnten auch konkave oder konvex-konkave Krümmungsverläufe erzeugt werden, ohne daß die Kontaktierung der Vorder- und Rückseiten 3, 5 beeinträchtigt wird.

Fig. 11 zeigt stark schematisiert das Bruchverhalten der rückseitenkontaktierten Solarzelle 1" von Fig. 9 im Falle einer zylindrischen konvexen Krümmung mit einer Krümmungsachse, die parallel zu den Fingern 8 verläuft. Die Bruchspalte 23 verlaufen hier - statistisch gesehen - hauptsächlich zwischen den Fingern 8, wodurch die Vorderseitenkontaktierung 7', 8 beim Bruchvorgang weitgehend unbeeinträchtigt bleibt; die Rückseitenkontaktierung 9, 10 verbiegt sich lediglich an den Stellen der Bruchspalte 23, bleibt aber sonst vollkommen intakt.

Fig. 14 zeigt stark schematisiert das sphärische konvexe Brechen der Solarzelle 1"' von Fig. 12. Es ist ersichtlich, daß die Bruchspalte 23 - statistisch gesehen - überwiegend zwischen den durchkontaktierten Kanälen 7 bzw. Emittern 7' verlaufen, sodaß auch hier die Kontaktierung der Vorderseite 3 weitgehend unbeeinträchtigt vom Bruchvorgang bleibt; die Rückseitenkontaktierung 9, 10 bleibt auch hier, abgesehen von Verbiegungen bzw. Knicken, intakt.

Falls gewünscht, können in allen Varianten 1', 1", 1"' mit Hilfe von Schwächungslinien 24 Sollbruchstellen vorgegeben werden, um ein Zerbrechen in regelmäßige Bruchstücke 22 zu fördern und/oder die Bruchspalte 23 so zu legen, daß sie die Vorder- und Rückseitenkontaktierungen möglichst wenig beeinflussen. Beispielsweise können bei der Solarzelle 1" auf einfache Weise mittels vorderseitiger Schwächungslinien 24 Bruchspalte 23 zwischen den Fingern 8 gefördert werden. Die Schwächungslinien 24 werden bevorzugt durch Ritzen mit einem Laser erzeugt.

Die Schwächungslinien 24 können durchgehende (kontinuierliche) oder unterbrochene ("strichlierte", "gepunktete") Linien sein. So können beispielsweise die vorderseitig drahtgitterkontaktierten Solarzellen 1' mit unterbrochenen Schwächungslinien 24 versehen werden, welche nur zwischen den Metalldrähten 4 verlaufen, oder die Schwächungslinien 24 werden vor dem Aufbringen der Metalldrähte 4 erzeugt.

Das gekrümmte Photovoltaik-Modul der Erfindung läßt sich für beliebige Anwendungszwecke einsetzen, beispielsweise zur Verkleidung von Fassaden, Straßenobjekten usw. Es ist auch möglich, das Einlaminieren (Fig. 1) und Krümmen unter gleichzeitigem Brechen (Fig. 2) in einem einzigen Schritt durchzuführen, z.B. indem die Preßplatten 17, 18 der Heizpresse 16 gleich entsprechend als Formstempel und Matrize ausgebildet werden.

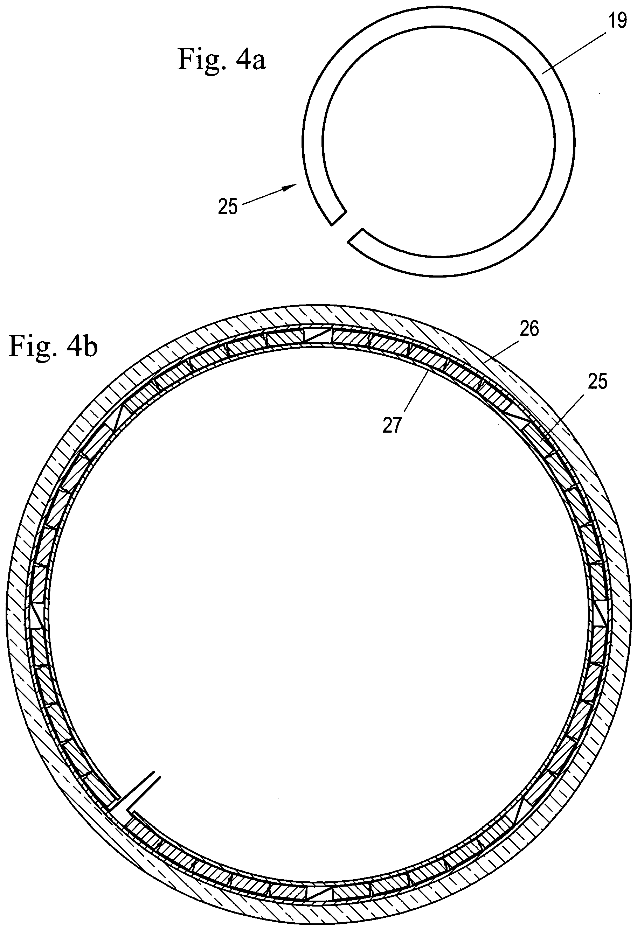

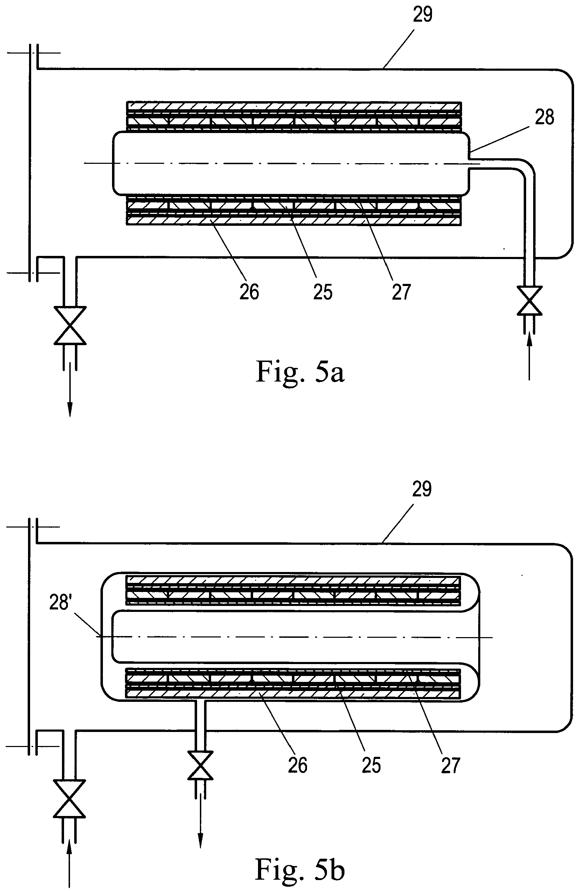

Eine weitere Variante des Verfahrens, die zur Herstellung eines rohrförmigen Photovoltaik-Moduls führt, wird anhand der Fig. 4 und 5 näher erläutert. Das nach dem Preßschritt von Fig. 1 erhaltene Laminat 19 wird hier - anstelle oder auch nach dem Krümmschritt der Fig. 2 und 3 - zu einem rohrförmigen Halbzeug 25 eingerollt (Fig. 4a) und in ein Glasrohr 26 eingebracht. Optional wird dabei auf die Innenseite des Halbzeugs 25 eine Schutzfolie 27 aufgelegt (Fig. 4b).

In das Innere dieser rohrförmigen Anordnung wird nun ein Preßschlauch 28 eingeführt und die gesamte Anordnung in einen Autoklaven 29 eingebracht (Fig. 5a). Durch Druckbeaufschlagung mittels des Preßschlauches 28 und Temperatureinwirkung mittels des Autoklaven 29 schmilzt die thermoplastische Deckschicht 13 des Laminats 19 wieder auf und verbindet sich mit der Innenseite des Glasrohres 26. Im Ergebnis wird das Halbzeug 25 auf die Innenseite des Rohres 26 auflaminiert. Wenn eine Schutzfolie 27 verwendet wird, wird auch diese gleichzeitig durch Wiedererwärmen der thermoplastischen Trägerschicht 12 des Laminats 19 auf die Innenseite des Halbzeugs 25 auflaminiert.

Anstelle eines druckbeaufschlagten Preßschlauches 28 kann auch ein vakuumbeaufschlagter, um die rohrförmige Anordnung aus Glasrohr 26, Halbzeug 25 und Schutzfolie 27 herum und in diese hineingestülpter Preßschlauch 28' verwendet werden (Fig. 5b), wie in der Technik bekannt. Bei der Ausführungsform der Fig. 5a kann das Innere des Autoklaven 29 zusätzlich evakuiert und bei jener der Fig. 5b zusätzlich unter Druck gesetzt werden, um den Laminiervorgang zu unterstützen.

Das auf diese Weise hergestellte rohrförmige Photovoltaik-Modul ist rundherum mit Solarzellen 1 ausgestattet. Ein solches rohrförmiges Photovoltaik-Modul eignet sich besonders als Standpfahl für solarbetriebene Leuchten, beispielsweise solarbetriebene Straßenlaternen. Durch die Rundumanordnung gekrümmter Solarzellen ist im gesamten Verlauf des Sonnenstandes eines Tages stets ein direkter Sonnenlichteinfall gegeben; überdies kann auch diffuses Licht von allen Seiten empfangen werden.

Die Erfindung ist nicht auf die dargestellten Ausführungsformen beschränkt, sondern umfaßt alle Varianten und Modifikationen, die in den Rahmen der angeschlossenen Ansprüche fallen.

## Patentansprüche

1. Verfahren zur Herstellung eines konvex gekrümmten Photovoltaik-Moduls aus ebenen kristallinen Solarzellen, **gekennzeichnet durch** die Schritte:
Einbetten zumindest einer ebenen kristallinen Solarzelle (1; 1", 1"') vom rückseitenkontaktierten Typ zwischen einer verformbaren Trägerschicht (12) und einer verformbaren Deckschicht (13), um ein Laminat (19) zu erzeugen, und
Krümmen des Laminats (19) zur gewünschten konvexen Form unter Verformen der Träger- und Deckschichten (12, 13) und gleichzeitigem Brechen der zumindest einen Solarzelle (1; 1", 1"') zu Bruchstücken (22), sodass die konvexe Form **durch** Polygonzüge der Bruchstücke (22) angenähert wird,
wobei die Bruchstücke (22) über eine sich an den Bruchstellen (23) verbiegende metallische Rückseitenkontaktierung (9, 10) miteinander verbunden bleiben.

2. Verfahren zur Herstellung eines gekrümmten Photovoltaik-Moduls ausgehend von ebenen kristallinen Solarzellen, **gekennzeichnet durch** die Schritte:
Einbetten zumindest einer ebenen kristallinen Solarzelle (1; 1') vom drahtgitterkontaktierten Typ zwischen einer verformbaren Trägerschicht (12) und einer verformbaren Deckschicht (13), um ein Laminat (19) zu erzeugen, und
Krümmen des Laminats (19) zur gewünschten Form unter Verformen der Träger- und Deckschichten (12, 13) und gleichzeitigem Brechen der zumindest einen Solarzelle (1, 1') zu Bruchstücken (22), sodass die konvexe Form **durch** Polygonzüge der Bruchstücke (22) angenähert wird,
wobei die Bruchstücke (22) über eine sich an den Bruchstellen (23) dehnende metallische Drahtgitterkontaktierung (4) miteinander verbunden bleiben.

3. Verfahren nach Anspruch 1 oder 2, **dadurch gekennzeichnet, daß** die Solarzelle (1; 1", 1"') vor dem Einbetten mit Schwächungslinien (24) versehen wird, um Sollbruchstellen für das Brechen zu erzeugen, bevorzugt durch Ritzen mit einem Laser.

4. Verfahren nach einem der Ansprüche 1 bis 3, **dadurch gekennzeichnet, daß** Träger- und Deckschichten (12, 13) aus thermoplastischen Folien verwendet werden und das Einbetten durch Einlaminieren der Solarzelle (1) in die Folien mittels einer Heizpresse (16) erfolgt.

5. Verfahren nach einem der Ansprüche 1 bis 4, **dadurch gekennzeichnet, daß** mehrere Solarzellen (1) flächig nebeneinanderliegend angeordnet, über flexible elektrische Leiter (11) verbunden und gemeinsam zwischen Träger- und Deckschicht (12, 13) eingebettet werden.

6. Verfahren nach einem der Ansprüche 1 bis 5, **dadurch gekennzeichnet, daß** das Krümmen durch Pressen des Laminats (19) zwischen einem Formstempel (20) und einer entsprechenden Matrize (21) erfolgt.

7. Verfahren nach einem der Ansprüche 1 bis 5 zur Herstellung eines rohrförmigen Photovoltaik-Moduls, **dadurch gekennzeichnet, daß** das Krümmen durch Einrollen des Laminats (19) zu einem rohrförmigen Halbzeug (25) erfolgt, welches anschließend in ein transparentes Rohr (26) eingebracht und auf dessen Innenseite auflaminiert wird, bevorzugt mit Hilfe eines in das Halbzeug (25) eingeführten Preßschlauches (28, 28').

8. Verfahren nach Anspruch 7 in Verbindung mit Anspruch 4, **dadurch gekennzeichnet, daß** das Auflaminieren des Halbzeugs (25) auf die Innenseite des Rohres (26) unter Wiedererwärmen der thermoplastischen Deckschicht (13) erfolgt.

9. Verfahren nach Anspruch 7 oder 8, **dadurch gekennzeichnet, daß** auf die Innenseite des Halbzeugs (25) eine Schutzfolie (27) auflaminiert wird, bevorzugt unter Wiedererwärmen der thermoplastischen Trägerschicht (12).

10. Verfahren nach einem der Ansprüche 4 bis 9, **dadurch gekennzeichnet, daß** die Träger- und Deckschichten (12, 13) in der Heizpresse (16) eine rauhe Oberflächenstruktur erhalten, bevorzugt durch Zwischenlegen von oberflächenstrukturierten Prägefolien oder -netzen (14, 15), die nach dem Preßvorgang entfernt werden.

11. Photovoltaik-Modul von konvex gekrümmter Form, **gekennzeichnet durch** ein Laminat aus zumindest einer ebenen kristallinen Solarzelle (1; 1", 1"') vom rückseitenkontaktierten Typ, die zwischen einer verformten Trägerschicht (12) und einer verformten Deckschicht (13) eingebettet und unter Krümmung des Laminats (19) zur gewünschten konvexen Form und Verformung der Träger- und Deckschichten (12, 13) zu Bruchstücken (22) zerbrochen ist, sodass die konvexe Form **durch** Polygonzüge der Bruchstücke (22) angenähert ist, wobei die Bruchstücke (22) über die an den Bruchstellen (23) verbogene metallische Rückseitenkontaktierung (9, 10) der zumindest einen Solarzelle (1; 1", 1"') miteinander verbunden sind.

12. Photovoltaik-Modul von gekrümmter Form, **gekennzeichnet durch** ein Laminat aus zumindest einer ebenen kristallinen Solarzelle (1; 1') vom drahtgitterkontaktierten Typ, die zwischen einer verformten Trägerschicht (12) und einer verformten Deckschicht (13) eingebettet und unter Krümmung des Laminats (19) zur gewünschten Form und Verformung der Träger- und Deckschichten (12, 13) zu Bruchstücken (22) zerbrochen ist, sodass die konvexe Form **durch** Polygonzüge der Bruchstücke (22) angenähert ist, wobei die Bruchstücke (22) über die an den Bruchstellen (23) gedehnte metallische Drahtgitterkontaktierung (4) der zumindest einen Solarzelle (1; 1') miteinander verbunden sind.

13. Photovoltaik-Modul nach Anspruch 11 oder 12, **dadurch gekennzeichnet, daß** die Solarzelle (1; 1", 1'") an vor dem Einbetten erzeugten Schwächungslinien (24) als Sollbruchstellen zu den Bruchstücken zerbrochen ist.

14. Photovoltaik-Modul nach einem der Ansprüche 11 bis 13, **dadurch gekennzeichnet, dass** die Träger- und Deckschichten (12, 13) aus thermoplastischen Folien sind und die Solarzelle (1) in die Folien mittels einer Heizpresse (16) einlaminiert ist.

15. Standpfahl für eine solarbetriebene Leuchte, umfassend zumindest ein Photovoltaik-Modul nach einem der Ansprüche 11 bis 14.

## Claims

1. Method for producing a convexly curved photovoltaic module from plane crystalline solar cells, **characterized by** the steps:
embedding at least one plane crystalline solar cell (1; 1", 1'") of backside contacted type between a deformable support layer (12) and a deformable cover layer (13) to create a laminate (19), and
bending the laminate (19) to the desired convex shape by deforming the support and cover layers (12, 13) and simultaneously breaking the at least one solar cell (1; 1", 1'") to fragments (22) such that the convex shape is approximated by polygon lines of the fragments (22),
wherein the fragments (22) stay connected to each other via a metallic backside contacting that is bended at the breaking points (23).

2. Method for producing a curved photovoltaic module from plane crystalline solar cells, **characterized by** the steps:
embedding at least one plane crystalline solar cell (1; 1') of wire grid contacted type between a deformable support layer (12) and a deformable cover layer (13) to create a laminate (19), and
bending the laminate (19) to the desired shape under deforming the support and cover layers (12, 13) and simultaneously breaking the at least one solar cell (1; 1", 1'") to fragments (22) such that the convex shape is approximated by polygon lines of the fragments (22),
wherein the fragments (22) stay connected to each other via a metallic wire grid contacting (4) that stretches at the breaking points (23).

3. Method according to claim 1 or 2, **characterised in that** the solar cell (1; 1", 1'") is provided with weakening lines (24) before embedding to create predetermined breaking points for breaking, preferably by means of scratching with a laser.

4. Method according to any one of the claims 1 to 3, **characterised in that** support and cover layers (12, 13) made out of thermoplastic sheets are used and the embedding is performed by laminating the solar cell (1) into the sheets by means of a heating press (16).

5. Method according to any one of the claims 1 to 4, **characterised in that** several solar cells (1) are arranged in a planar manner next to each other, are connected via flexible electrical conductors (11), and are embedded together between the support and cover layers (12, 13).

6. Method according to any one of the claims 1 to 5, **characterised in that** the bending is performed by pressing the laminate (19) between a form punch (20) and a corresponding die (21).

7. Method according to any one of the claims 1 to 5 for producing a tubular photovoltaic module, **characterised in that** the bending is performed by rolling the laminate (19) to a tubular semi-manufactured product (25), which is subsequently introduced into a transparent tube (26) and laminated onto the inner side thereof, preferably by means of a pressing hose (28, 28') introduced into the semi-manufactured product (25).

8. Method according to claim 7 in combination with claim 4, **characterised in that** the laminating of the semi-manufactured product (25) onto the inner side of the tube (26) is performed by re-heating the thermoplastic cover layer (13).

9. Method according to claim 7 or 8, **characterised in that** a protection sheet (27) is laminated onto the inner side of the semi-manufactured product (25), preferably by means of re-heating the thermoplastic support layer (12).

10. Method according to any one of the claims 4 to 9, **characterised in that** the cover and support layers (12, 13) obtain a rough surface structure in the heating press (16), preferably by interposing surface-structured embossing sheets or nets (14, 15) that are removed after pressing.

11. Photovoltaic module having a convexly curved shape, **characterized by** a laminate of at least one plane crystalline solar cell (1; 1", 1'") of backside contacted type, which is embedded between a deformed support layer (12) and a deformed cover layer (13) and broken to fragments (22) by bending the laminate (19) to the desired convex shape and deforming the support and cover layers (12, 13), such that the convex shape is approximated by polygonal lines of the fragments (22), wherein the fragments (22) are connected to each other via the metallic backside contacting (9, 10), bent at the breaking points (23), of the at least one solar cell (1; 1", 1'").

12. Photovoltaic module having a curved shape, **characterized by** a laminate of at least one plane crystalline solar cell (1; 1", 1'") of wire grid contacted type, which is embedded between a deformed support layer (12) and a deformed cover layer (13) and broken to fragments (22) by bending the laminate (19) to the desired shape and deforming the support and cover layers (12, 13), such that the convex shape is approximated by polygonal lines of the fragments (22), wherein the fragments (22) are connected to each other via the metallic wire grid contacting (4), stretched at the breaking points (23), of the at least one solar cell (1; 1", 1'").

13. Photovoltaic module according to claim 11 or 12, **characterised in that** the solar cell (1; 1", 1'") is broken to the fragments at weakening lines (24), which were generated before embedding, as predetermined breaking points.

14. Photovoltaic module according to any one of the claims 11 to 13, **characterised in that** the support and cover layers (12, 13) are made out of thermoplastic sheets and the solar cell (1) is laminated into the sheets by means of a heating press (16).

15. Pole for a solar powered lamp, comprising at least one photovoltaic module according to any one of the claims 11 to 14.

## Revendications

1. Procédé de fabrication d'un module photovoltaïque de courbure convexe à partir de cellules solaires cristallines planes, **caractérisé par** les étapes :
d'ensevelissement d'au moins une cellule solaire cristalline plane (1 ; 1", , 1'") du type à contact arrière entre une couche de support (12) déformable et une couche de revêtement (13) déformable, afin de créer un stratifié (19), et
de pliage du stratifié (19) dans la forme convexe souhaitée, moyennant la déformation des couches de support et de revêtement (12, 13) et la rupture simultanée de l'au moins une cellule solaire (1 ; 1", 1'") en morceaux (22), de sorte que l'on se rapproche de la forme convexe par la suite polygonale des morceaux (22),
où les morceaux (22) restent liés ensemble par l'intermédiaire du contact arrière métallique (9, 10) se pliant aux endroits des ruptures (23).

2. Procédé de fabrication d'un module photovoltaïque courbé en partant de cellules solaires cristallines planes, **caractérisé par** les étapes :
d'ensevelissement d'au moins une cellule solaire cristalline plane (1 ; 1') du type à contact par treillis métallique entre une couche de support (12) déformable et une couche de revêtement (13) déformable, afin de créer un stratifié (19), et
de pliage du stratifié (19) dans la forme souhaitée, moyennant la déformation des couches de support et de revêtement (12, 13) et la rupture simultanée de l'au moins une cellule solaire (1 ; 1') en morceaux (22), de sorte que l'on se rapproche de forme convexe par la suite polygonale des morceaux (22),
où les morceaux (22) restent liés ensemble par l'intermédiaire d'un contact par treillis métallique (4) s'étirant aux endroits des ruptures (23).

3. Procédé selon la revendication 1 ou 2, **caractérisé en ce que** la cellule solaire (1 ; 1", 1'") est munie de lignes de faible résistance (24) avant l'ensevelissement, afin de créer des points de rupture souhaitée pour la rupture, de préférence par des rayures avec un laser.

4. Procédé selon l'une des revendications 1 à 3, **caractérisé en ce que** des couches de support et de revêtement (12, 13) à base de films thermoplastiques sont employées et l'ensevelissement est effectué par une incorporation par stratification de la cellule solaire (1) dans les films au moyen d'une presse à chaud (16).

5. Procédé selon l'une des revendications 1 à 4, **caractérisé en ce que** plusieurs cellules solaires (1) sont disposées de manière plane les unes à côté des autres, sont reliées par des conducteurs (11) électriques souples et sont ensevelies ensemble entre les couches de support et de revêtement (12, 13).

6. Procédé selon l'une des revendications 1 à 5, **caractérisé en ce que** le pliage est effectué par une compression du stratifié (19) entre un poinçon de moulage (20) et une matrice (21) correspondante.

7. Procédé selon l'une des revendications 1 à 5, pour la fabrication d'un module photovoltaïque en forme de tube, **caractérisé en ce que** le pliage est réalisé par un enroulement du stratifié (19) en un semi produit (25) en forme de tube, lequel est ensuite inséré dans un tube (26) transparent et est incorporé par stratification contre sa face intérieure, de préférence à l'aide d'un tuyau de pressage (28, 28') inséré dans le semi produit (25).

8. Procédé selon la revendication 7, en relation avec la revendication 4, **caractérisé en ce que** l'incorporation par stratification du semi produit (25) sur la face intérieure du tube (26) a lieu moyennant un nouveau réchauffement de la couche de revêtement (13) thermoplastique.

9. Procédé selon la revendication 7 ou 8, **caractérisé en ce qu'**un film de protection (27) est rapporté par stratification sur la face intérieure du semi produit (25), de préférence moyennant un nouveau réchauffement de la couche de support (12) thermoplastique.

10. Procédé selon l'une des revendications 4 à 9, **caractérisé en ce que** les couches de support et de revêtement (12, 13) obtiennent une structure de surface rugueuse dans la presse à chaud (16), de préférence par un intercalage de films de marquage ou de mouillage (14, 15) structurés en surface qui sont enlevés après le processus de compression.

11. Module photovoltaïque de forme courbe convexe, **caractérisé par** un stratifié composé d'au moins une cellule solaire (1 ; 1", 1'") cristalline plane de type à contact arrière qui est ensevelie entre une couche de support (12) déformé et une couche de revêtement (13) déformé et est cassée moyennant le pliage du stratifié (19) dans la forme convexe souhaitée et la déformation des couches de support et de revêtement (12, 13) en morceaux (22) de sorte que l'on se rapproche de la forme convexe par la suite polygonale des morceaux (22), où les morceaux (22) sont reliés ensemble par l'intermédiaire du contact arrière (9, 10) plié dans les endroits des ruptures (23) de l'au moins une cellule solaire (1 ; 1", 1'").

12. Module photovoltaïque de forme courbe **caractérisé par** un stratifié composé d'au moins une cellule solaire (1 ; 1') cristalline plane de type à contact par treillis métallique, qui est ensevelie entre une couche de support (12) déformé et une couche de revêtement (13) déformé et est cassée moyennant le pliage du stratifié (19) dans la forme convexe souhaitée et la déformation des couches de support et de revêtement (12, 13) en morceaux (22) de sorte que l'on se rapproche de la forme convexe par la suite polygonale des morceaux (22), où les morceaux (22) sont reliés ensemble par l'intermédiaire du contact par treillis métallique (4) étiré aux endroits des ruptures (23) de l'au moins une cellule solaire (1 ; 1').

13. Module photovoltaïque selon la revendication 11 ou 12, **caractérisé en ce que** la cellule solaire (1 ; 1", 1'") est cassée en morceaux au niveau des lignes de faible résistance (24) générées avant l'ensevelissement sous la forme de points de rupture souhaitée.

14. Module photovoltaïque selon l'une des revendications 11 à 13, **caractérisé en ce que** les couches de support et de revêtement (12, 13) sont à base de films thermoplastiques et la cellule solaire (1) est incorporée par stratification dans les films au moyen d'une presse à chaud (16).

15. Poteau pour un éclairage à énergie solaire comprenant au moins un module photovoltaïque selon l'une des revendications 11 à 14.
